(19) Europäisches Patentamt
European Patent Office
Office européen des brevets

(11) Publication number: 0 222 878 B1

# (12) EUROPEAN PATENT SPECIFICATION

(45) Date of publication of patent specification: 05.12.90

(51) Int. Cl.[5]: C 08 F 2/50, C 08 F 4/40, C 08 F 20/58

(21) Application number: 86903785.3

(22) Date of filing: 07.05.86

(86) International application number: PCT/US86/01012

(87) International publication number: WO 86/06730 20.11.86 Gazette 86/25

## (54) AQUEOUS ALKALINE DEVELOPABLE, UV CURABLE URETHANE ACRYLATE COMPOUNDS AND COMPOSITIONS USEFUL FOR FORMING SOLDER MASK COATINGS.

(30) Priority: 17.05.85 US 735411
20.06.85 US 747090
21.06.85 US 747478

(43) Date of publication of application: 27.05.87 Bulletin 87/22

(45) Publication of the grant of the patent: 05.12.90 Bulletin 90/49

(84) Designated Contracting States: AT BE CH DE FR GB IT LI LU NL SE

(56) References cited:
US-A-3 682 808
US-A-4 108 840
US-A-4 116 788
US-A-4 189 365
US-A-4 228 232
US-A-4 269 931
US-A-4 372 836

(73) Proprietor: ATOCHEM NORTH AMERICA, INC. (a Pennsylvania corp.)
Three Parkway
Philadelphia Pennsylvania 19102 (US)

(72) Inventor: HUNG, Paul, Ling, Kong
428 Durham Avenue
Edison, NJ 08817 (US)
Inventor: LAVACH, Mark, L.
1833 4th Avenue
Toms River, NJ 08757 (US)
Inventor: TSENG, Kenneth, Kuo-shu
19 Traci Lane
Edison, NJ 08817 (US)

(74) Representative: van der Kloet-Dorleijn, Geertruida W.F., Drs. et al
EXTERPATENT Willem Witsenplein 4
NL-2596 BK 's-Gravenhage (NL)

EP 0 222 878 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to solder mask coatings having improved performance characteristics, and, more particularly, it is concerned with aqueous alkaline developable, UV curable urethane acrylate compounds and compositions useful for making such coatings.

U.S. Patent 4,506,004, describes a contact method of imaging a liquid solder mask coating on a printed circuit board. In this method, the UV curable solder mask coating is screen printed to a given thickness, prehardened and imaged by exposure with suitable UV energy. The desired characteristics of good electrical performance and excellent printing resolution are given as the attributes of the Sullivan system. The requirements of a suitable photopolymerizable compound for use in this process include an ability to form a smooth, flexible coating which can impart chemical and heat resistance to the solder mask. Furthermore, the coating must exhibit excellent adhesion to the board, and an ability to be cured to a desired depth with a minimum of UV energy.

An advantageous feature of a solder mask coating is an ability to be developed with an aqueous, slightly alkaline solution, thereby avoiding the use of organic solvents in the developing step. The solder mask coatings also should exhibit flexibility, heat and chemical resistance, surface hardness, abrasion resistance, adhesion to the underlying metal of the printed circuit board, and a high cure depth at low dosages. These stringent requirements imply that the structure of the prepolymer and its formulation must be carefully designed before the solder mask can achieve commercial acceptability. Photosensitive compositions which comprise (1) an ethylenically unsaturated free radical polymerizable end-capped oligomer, the bridging oligomeric portion between the unsaturated capping groups having carboxyl group substitution thereon, (2) a polymeric binder, (3) at least one free radical polymerizable monomer having at least one ethylenically unsaturated group, and (4) a radiation sensitive initiator system capable of initiating free radical polymerization upon absorption of electromagnetic radiation.

A storage stable photosensitive imaging element of particular use in providing base developable printing plates can be made by applying the photosensitive compositions to a support layer.

Particularly improved compositions comprising the photosensitive oligomers, limited classes of binder, polymerizable monomers, and photoinitiation systems have unexpectedly high radiation sensitivity and no oxygen or moisture sensitivity.

Coatings obtained by using this knoiwn composition are nevertheless non-flexible.

The invention now provides a UV curable, aqueous alkaline developable urethane acrylate compound and composition which does not have this drawback.

The composition according to the invention is characterized in that the diisocyanate used is an aliphatic or cycloaliphatic diisocyanate.

Said diisocyanate compound is selected from the group consisting of aliphatic and cycloaliphatic diisocyanates, e.g. dicyclohexylmethylene diisocyanate, isophorone diisocyanate, and hexamethylene diisocyanate.

The urethane acrylate compound of the invention is further characterized by the following: (a) terminal ethylenic unsaturation; (b) at least one terminal carboxylic acid group; and (c) alkylene connecting groups intermediate said terminal groups, one of which is preferably substituted with at least one hydroxy group.

Further, this invention provides a UV curable, aqueous alkaline developable urethane acrylate solder mask composition comprising:

(a) 40—70% by weight of (i) the above described urethane acrylate compound, or (ii) a mixture of 20—99% by weight of the urethane acrylate and 1—80% by weight of a urethane diacrylate, made by reacting said diisocyanate with 2 moles of a hydroxyalkyl acrylate;

(b) 20—50% by weight of one or more reactive diluent monomers;

(c) 0.5—10% by weight of a photoinitiator; and

(d) 0—8% by weight of triphenylphosphite.

The composition also may include about 1—5% by weight of one or more of the following: a crosslinking agent, a pigment or dye, a rheology modifier, and a thermal stabilizer; and 1—15% by weight of a filler.

A feature of the invention is the provision of a printed circuit board having a cured solder mask coating thereon which can be screen printed to form a smooth, uniform, glossy, flexible coating. This solder mask coating can be cured at a low energy level to provide a high cure depth and excellent surface hardness, and abrasion, heat and organic solvent resistance. The coating can be developed rapidly in an aqueous, slightly alkaline medium at room temperature.

Another feature of the invention is the provision of a UV curable urethane acrylate compound having a high degree of terminal ethylenic unsaturation per unit weight, which enables curing to take place at low energy levels. The compound has at least one terminal carboxylic group so that the cured coating can be developed rapidly in an aqueous, slightly alkaline medium. The compound is further characterized by the presence of an alkylene connecting group intermediate the terminal groups, which is preferably substituted with a hydroxyl group, which increases the aqueous solubility of the compound.

The UV curable, aqueous alkaline developable urethane acrylate compound can be obtained by a three-step, two-part reaction sequence, the first step of which involves reacting a suitable diisocyanate compound with one mole of a hydroxy-alkylacrylate to form the corresponding isocyanate-capped

acrylate. Suitable diisocyanates for use in this step including aliphatic and cycloaliphatic diisocyanates, e.g. dicyclohexylmethane diisocyanate, isophorone diisocyanate, hexamethylene diisocyanates, and trimethylhexamethylene diisocyanate.

The hydroxyalkyl acrylate reactant may be selected from such compounds as hydroxymethyl acrylate, hydroxyethyl acrylate, hydroxypropyl acrylate, hydroxybutyl acrylate and the like, although other acrylates known in the art may be used as well. For purposes of this invention the term "acrylate" includes the corresponding "methacrylate" derivatives.

The second step in the reaction sequence is esterification of a suitable polyol reactant with a dicarboxylic acid anhydride to form an ester of the dicarboxylic acid. Suitable polyols have at least three, and up to six, hydroxyl groups in the molecule, and include such compounds as glycerol, trimethylolpropane, 1,2,6-hexanetriol, caprolactone polyol, and sugars, such as fructose. Glycerol is preferred.

To improve heat resistance of the solder mask, part of the polyol, e.g. about 20% mole thereof, may include a suitable sulfur-containing diol, e.g. dihydroxydiphenylsulfone or the corresponding sulfide.

Suitable dicarboxylic acid anhydrides for this step include such acid anhydrides as maleic anhydride, succinic anhydride, glutaric anhydride, adipic anhydride, phthalic anhydride and the like. Maleic anhydride is preferred.

In carrying out this reaction, for example, with a triol, one mole of the acid anhydride is used, thus forming the monoester intermediate, and leaving two hydroxyl groups available for subsequent reaction. One hydroxyl group then will be substituted on the alkylene group in the final product. The corresponding diesters also may be prepared by using two moles of the acid anhydride, in which case two terminal carboxylic acid groups will be present in the final compound.

The third and final step in the process is the condensation of the isocyanate-capped acrylate with the ester of the dicarboxylic acid anhydride. The final reaction is characterized by terminal ethylenic unsaturation at one end, and at least one terminal carboxylic acid group at the other end, with the organic diisocyanate moiety attached to the unsaturated group, and an alkylene group adjacent said terminal acid group. Preferably, a hydroxyl group is present as a substituent on the alkylene group. Two terminal carboxylic acid groups also may be included in the final compound.

The desired urethane acrylate may be prepared by a three-step, one-pot synthesis wherein the four reactants are added sequentially in the same reaction vessel. In this method, the diisocyanate is charged and the hydroxyalkyl acrylate is added slowly. After an initial reaction between these reactants, the polyol is added, followed by the dicarboxylic acid anhydride.

The reaction sequence is given below.

Method of preparing urethane acrylate compound of invention

a) $OCN{-}R_1{-}NCO + HOR_2{-}O\overset{O}{\overset{\|}{C}}CH{=}CH_2 \rightarrow$

diisocyanate — hydroxyalkyl acrylate

$$CH_2{=}CH\overset{O}{\overset{\|}{C}}{-}O{-}R_2O\,\overset{O}{\overset{\|}{C}}{-}NHR_1NCO \qquad (I)$$

isocyanate-capped alkyl acrylate

where

$R_1$ is aliphatic or cycloaliphatic, and

$R_2$ is alkylene;

b) $R_3(OH)_x + n$ 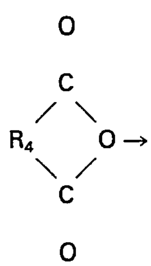

polyol

dicarboxylic acid anhydride

$$R_3(OH)_{x-n}{-}(O{-}\overset{O}{\overset{\|}{C}}{-}R_4{-}COOH)_n \qquad (II)$$

polyacid ester

where

x is 3—6,

n is 1—5,

(x-n) is a positive integer,

$R_3$ is alkylene, and

$R_4$ is aliphatic or cycloaliphatic, saturated or unsaturated, or aromatic;

$$\text{c) (I)+(II)} \rightarrow H_2C{=}CH\overset{\overset{\large O}{\|}}{C}OR_2{-}O\overset{\overset{\large O}{\|}}{C}{-}NHR_1NH{-}\overset{\overset{\large O}{\|}}{C}{-}OR_3(OH)_y(O\overset{\overset{\large O}{\|}}{C}R_4COOH)_n$$

urethane acrylate (III)

where y is 0—4, provided, however, that if y is 0, then n is at least 2.

As an illustration of the invention, the reaction of dicyclohexylmethylene diisocyanate, one mole of hydroxypropyl acrylate, glycerol and one mole of maleic anhydride is as follows:

a) 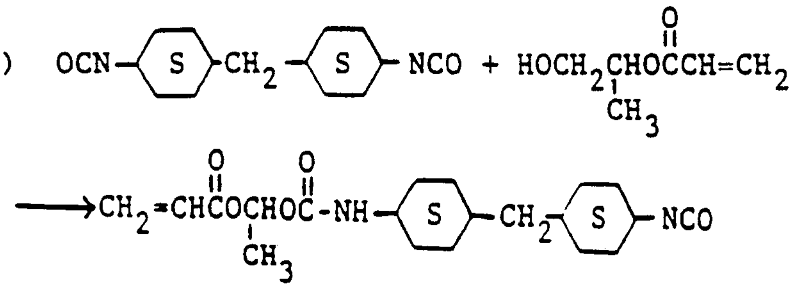

(I)

b) 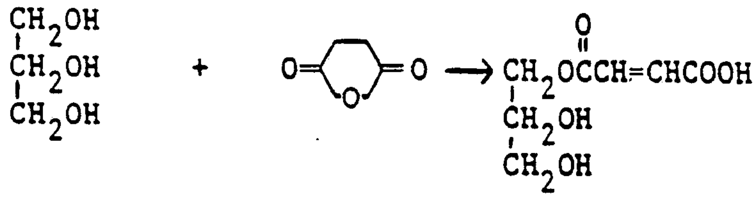

(II)

c) 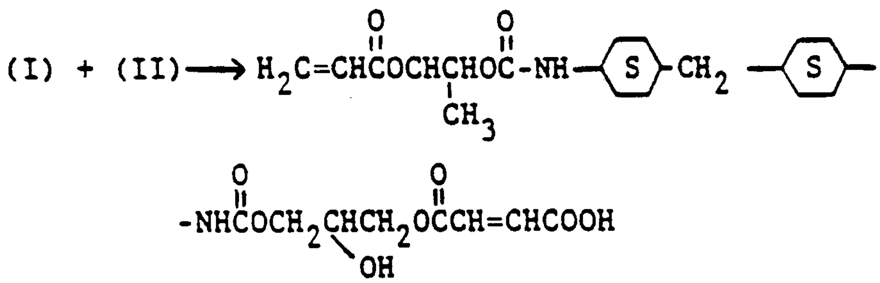

(III)

With 2 moles of maleic anhydride the reaction sequence is as follows:

b) 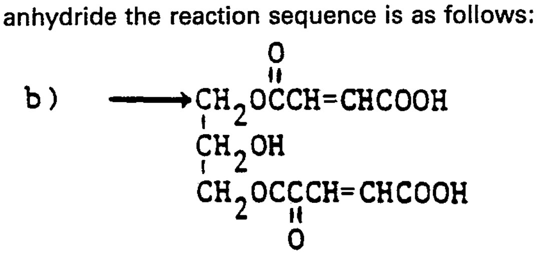

(IV)

c.) 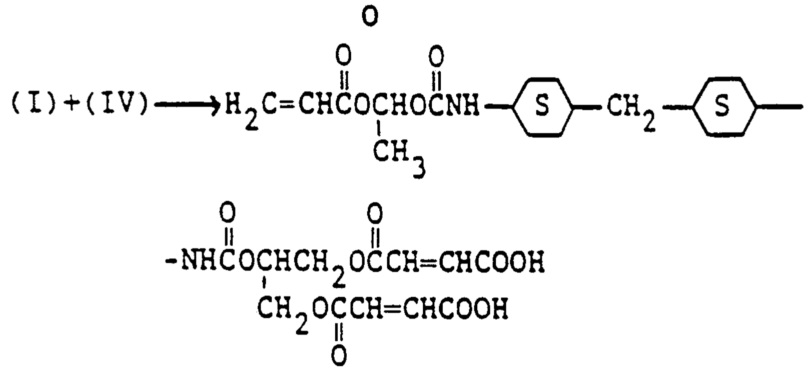

(V)

This invention also provides a UV curable, aqueous alkaline developable urethane acrylate composition for forming a soldering mask comprising:

a) 40—80% by weight of (i) a urethane acrylate compound which is obtained by reacting substantially equal molar quantities of an aliphatic or cycloaliphatic diisocyanate and a hydroxyalkyl acrylate, with a polyol having at least three hydroxyl groups, and at least one mole of a dicarboxylic acid anhydride per mole of said polyol; or (ii) a mixture of 20—99% by weight of the urethane acrylate and 1—80% by weight of a urethane diacrylate;

b) 20—50% by weight of a reactive monomer diluent;

c) 0.5—10% of a photoinitiator; and

d) 0—8% by weight of a triphenylphosphite.

The reactive diluent monomers are added to the urethane acrylates of the invention to reduce its viscosity in the composition, and increase the curing rate. Suitable reactive diluent monomers for use herein include ethylenically unsaturated monomers that are compatible and copolymerizable with the substituted urethane acrylates of the invention. Such ethylenically unsaturated monomers include mono-, di- and tri-acrylates as, for example, hydroxyalkyl acrylates, such as e.g. hydroxyethyl acrylate; and acrylate esters, e.g. methyl methacrylate, ethyl acrylate, 2-ethylhexyl acrylate, cyclohexyl acrylate, isobutoxymethyl methacrylate, t-butyl acrylate, methyl acrylate, butyl acrylate, 2-(N-ethylcarbamyl)ethyl methacrylate; aryloxyalkyl acrylates, e.g. phenoxyethyl acrylate; bis-phenol-A diacrylate, ethylene glycol diacrylate, polyethylene glycol diacrylate, glycerol diacrylate and methacrylate, bis-phenol A diacrylate, tetrapropylene glycol diacrylate, and the like. Suitable triacrylates include glycerol triacrylate, ethoxylated trimethylol triacrylate, and the like.

Other reactive compounds can be included in the composition of the invention to increase the crosslinking density of the coating. Such reactive compounds include, but are not limited to, pentaerythritol 3-mercaptopropionate, 1,4-butylene dimethacrylate or acrylate, 1,1,6,6-tetrahydroperfluorohexanediol diacrylate, ethylene dimethacrylate, glycerol diacrylate or methacrylate, glycerol trimethacrylate, diallyl phthalate and 1,3,5-tri(2-methacryloxyethyl)-s-triazine.

The UV curable composition also contains a photoinitiator which generates free radicals owing to actinic light. Suitable examples of such photoinitiators include substituted and unsubsubstituted polynuclear quinones, such as 2-ethylanthraquinone, 2-t-butylanthraquinone, octamethylanathraquinone, 1,2-benzanthraquinone, 2,3-diphenylanthraquinone, thioxanthone, e.g. chloro and isopropyl derivates, and the like; ketoaldonyl compounds such as, as diacetyl, benzyl and the like; α-ketoaldonyl alcohols and ethers, such as benzoin, pivalone, and the like; α-hydrocarbon-substituted aromatic acyloins such as α-phenylbenzoin, α,α-diethoxyacetophenone, and the like; and aromatic ketones such as benzophenone, 4,4'-bisdialkylaminobenzophenone, and the like. These photoinitiators may be used alone or as a combination of two or more of them. Examples of combinations include 2,4,5-triarylimidazole dimer and 2-mercaptobenzoquinazole, leucocrystal violet, tris(4-diethylamino-2-methylphenyl)methane, or the like, and the compounds which may not have photoinitiating properties alone but which nevertheless can constitute a good photoinitiating system, in combination with the above-mentioned materials. Such compounds include, for example, tertiary amines, such as triethanolamine and the like, which are used in combination with benzophenone. These photoinitiators and/or photoinitiator systems preferably are present in an amount of about 0.5 to 10% by weight of the composition.

The urethane diacrylate compound is obtained by reacting (i) at least one diisocyanate compound selected from the group consisting of aliphatic, cycloaliphatic and diisocyanates, e.g. dicyclohexyl methylene diisocyanate, isophorone diisocyanate, hexamethylene diisocyanate with (ii) two moles of a hydroxyalkyl acrylate, e.g. hydroxypropyl acrylate.

The urethane acrylate component of the mixture of UV curable compounds provides flexibility characteristics, aqueous alkaline developability, adhesion, surface hardness, and high cure depth at a low energy level; while the urethane diacrylate provides enhanced electrical insulation resistance.

The triphenylphosphite is present in an effective amount, suitably about 0.1 to 8% by weight of the composition, preferably about 0.4 to 5%, and, optimally, about 3%. In combination with a photoinitiator, the triphenylphosphite additive in the composition of the invention provides a cure depth of at least 305 * $10^{-6}$ m at an energy level of 0.2 $J/cm^2$.

The composition with triphenylphosphite is further characterized by stability toward gelation for long periods of time, and the retention of the other desirable properties of a commercial solder mask composition.

Example 1

3-Step, One-Pot Synthesis of Urethane Acrylate (1)

Desmondur W/HPA/Glycerol/Maleic Anhydride (1)

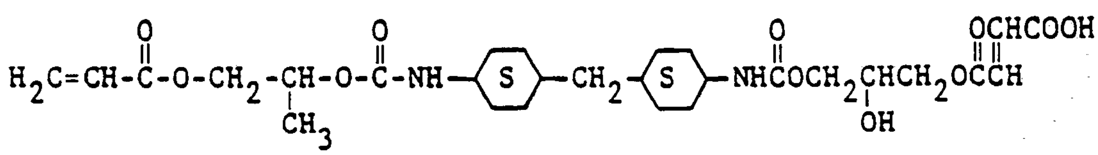

(1)

| | Parts | Equivalents |
|---|---|---|
| A. 4,4'-dicyclohexylmethylene diisocyanate (Desmondur W, trademark) | 262 | 2 |
| B. Dibutyltin dilaurate | 1.7 | 2000 ppm |
| C. Hydroxylpropyl acrylate (HPA) | 130 | 1 |
| D. Phenoxyethyl acrylate | 250 | 1.3 |
| E. Glycerol | 92.1 | 1 |
| F. Maleic anhydride | 98 | 1 |
| G. Hydroquinone methyl ether | 1.7 | 2000 ppm |

A resin kettle equipped with a mechanical stirrer, thermometer, drying tube and pressure equalizing dropping funnel was charged with (A), (B) and (D). The mixture then was stirred while (C) was added slowly over 20 min. The temperature was maintained at below 55°C. Upon completion of the addition, the mixture was maintained at 55°—60°C. until the NCO number was 10.7 ± 0.3, as determined by titration. (E) then was added slowly over 30 min. and the temperature was maintained at below 55°C. Heating was continued at 60°C. until IR showed the absence of NCO absorption at 2275 $cm^{-1}$. (F) then was added to the reaction mixture at 70—75°C. over 20 min., followed by (G). Heating was continued at 75°C. until the maleic anhydride was completedly reacted, as indicated by the absence of peaks at 1845 and 1975 $cm^{-1}$.

The product was a viscous liquid having a Brookfield viscosity of 640 g/(cm.sec) 25°C., and an acid group contents of 1.48 meq/g.

Example 2

3-Step, One-Pot Synthesis of Urethane Acrylate (2)

Desmondur W/HPA/Glycerol/(Maleic Anhydride)$_2$ (2)

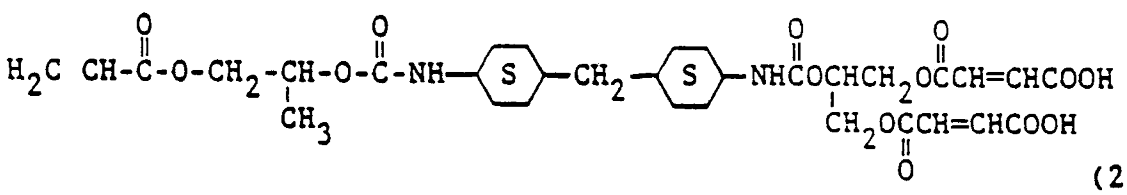

(2)

| | Parts | Equivalents |
|---|---|---|
| A. 4,4'-dicyclohexylmethylene diisocyanate | 262 | 2 |
| B. Dibutyltin dilaurate | 1.9 | 2000 ppm |
| C. Hydroxypropyl acrylate | 130 | 1 |
| D. Phenoxyethyl acdrylate | 291.5 | 1.52 |
| E. Glycerol | 92.1 | 1 |
| F. Maleic anhydride | 196 | 2 |
| G. Hydroquinone methyl ether | 1.9 | 2000 ppm |

A resin kettle equipped with a mechanical stirrer, thermometer, drying tube and pressure equalizing dropping funnel was charged with (A), (B) and (D). The mixture then was stirred while (C) was added slowly over 20 min. The temperature was maintained at below 55°C. Upon completion of the addition, the mixture was maintained at 55°—60°C. until the NCO number was 10.7 ± 0.3, as determined by titration. (E) than was added slowly over 30 min. and the temperature was maintained at below 55°C. Heating was continued at 60°C. until IR showed the absence of NCO absorption at 2275 $cm^{-1}$. (F) then was added to the reaction mixture at 70—75°C. over 20 min., followed by (G). Heating was continued at 75°C. until the maleic anhydride was completely reacted, as indicated by the absence of peaks at 1845 and 1975 $cm^{-1}$.

The product was a viscous liquid having a Brookfield viscosity of 3.200 g/(cm.sec) at 25°C., and an acid group contents of 2.60 meq/g.

Example 3

| 3-Step, 2-Pot Synthesis of Urethane Acrylate of Ex. 1 | Parts | Equivalents |
|---|---|---|
| A. 4,4′-dicyclohexylmethylene diisocyanate | 262 | 2 |
| B. Dibutyltin dilaurate | 1.7 | 2000 ppm |
| C. Hydroxylpropyl acrylate | 130 | 1 |
| D. Phenoxyethyl acrylate | 168 | |
| E. Glycerol | 92.1 | |
| F. Maleic anhydride | 98 | |
| G. Phenoxyethyl acrylate | 82 | |
| H. Hydroquinone methyl ether | 1.7 | 2000 ppm |

A resin kettle, equipped with a mechanical stirrer, thermometer, drying tube and pressure equalizing dropping funnel was charged with (A), (B) and (D). The mixture was stirred while (C) was added slowly over 20 min. The temperature was maintained at below 55°C. Upon completion of the addition, the mixture was maintained at 55°—60°C until the NCO number was 10.7 ↓ 0.3 as determined by titration. In another resin kettle equipped with a mechanical stirrer, a thermometer and drying tube was charged with (E), (F) and (G). The mixture was heated with stirring at 90°C. until the maleic anhydride was completely reacted, as indicated by the absence of peaks at 1845 and 1975 $cm^{-1}$. This product was then added to the intermediate prepared in the first kettle, described above, over 45 min. at a temperature below 55°C. The reaction temperature was maintained at 60°C. until an infrared spectrum showed the absence of NCO absorption peak at 2275 $cm^{-1}$. (H) then was added and the mixture stirred until (H) completely dissolved. The product was a viscous liquid have a viscosity of 720 g/(cm.sec) at 25°C., and acid group contents of 1.23 meq/g.

Example 4

The following composition was prepared using the urethane acrylate of Example 1, and then used in forming a solder mask for a printed circuit board.

COMPOSITION

| Component | Parts by Wt. |
|---|---|
| Urethane acrylate of Ex. 1 | 60.0 |
| Tone-100 (trademark of Union Carbide) reactive diluent monomer | 25.5 |
| Pentaerythritol 3-mercaptopropionate-cross-linker | 3.0 |
| CAB-O-SIL trademark of thioxotropic agent | 4 |
| Cymel 301 (trademark of Am. Cyan.) — cross-linker | 5 |
| IRG 651 (trademark of Ciba-Geigy) photoinitiator | 2 |
| CNF 853 — green pigment | 1 |
| Colloid 640 (trademark of Colloid Chem.) leveling agent | 0.8 |
| MTBHQ — mono-tert.-butyl hydroquinone-stabilizer | 0.2 |

This composition is thixotropic with a Brookfield viscosity of 2.080 g/(cm.sec) at 25°C at 0.5 rpm. and 392 g/(cm.sec) at 100 rpm., and is stable without gelations for more than 6 months.

Example 5

Preparation of Urethane Diacrylate

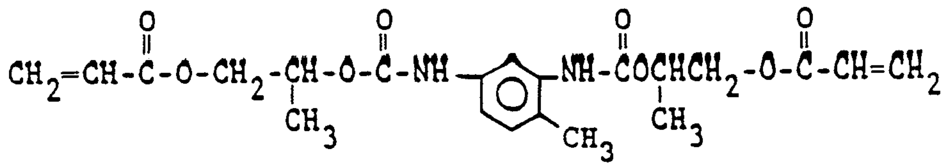

Toluene diisocyanate (1 mole) and hydroxypropyl acrylate (2 moles) are reacted at 550°C. for 6 hrs. to give the product, which was a viscous liquid having a Brookfield viscosity of 1.000 g/(cm.sec) at 25°C.

Example 6

The following composition was prepared using a UV curable mixture of equal weight quantities of the urethane acrylate of Example 1, and the urethane diacrylate of Example 5. The composition was used in forming a solder mask composition for a printed circuit board.

COMPOSITION

| Composition | Parts by Wt. |
|---|---|
| Urethane acrylate of Ex. 1 | 30.0 |
| Urethane diacrylate of Ex. 5 | 30.0 |
| Tone-100 (trademark of Union Carbide) reactive diluent monomer | 25.5 |
| Pentaerythritol 3-mercaptopropionate-cross-linker | 3.0 |
| CAB-O-SIL trademark of thioxotropic agent | 4 |
| Cymel 301 (trademark of Am. Cyan.) — cross-linker | 5 |
| IRG 651 (trademark of Ciba-Geigy) photoinitiator | 2 |
| CNF 853 — green pigment | 1 |
| Colloid 640 (trademark of Colloid Chem.) leveling agent | 0.8 |
| MTBHQ — mono-tert.-butyl hydroquinone-stabilizer | 0.2 |

This composition is thixotropic with a Brookfield viscosity of 2080 g/(cm.sec) at 25°C at 0.5 rpm. and 392 g/(cm.sec) at 100 rpm., and is stable without gelation for more than 6 months.

Example 7

SOLDER MASK

A copper-clad epoxy fiber glass printed circuit board was cleaned by scrubbing to remove corrosion and foreign material, coated by screen printing with the above composition of Example 1 to a thickness of about 76,2 * $10^{-6}$ m. Then a similar 76,2 * $10^{-6}$ m thick coating was applied on a photo tool in accordance with the method given in U.S. 4,506,004, Example 2. The two coatings then were given a flash curing with about 0.2—0.4 joules per $cm^2$ of energy using a mercury vapor lamp, to effect partial hardening. The two coatings were then mated to form a composite of 152,4 * $10^{-6}$ m thickness, flipped over and given a main exposure with 0.5 joules per $cm^2$ for 30 seconds. The unexposed coating then was developed by removing it (negative working) in a 1% sodium carbonate solution (pH 11) at room temperature for 4 min., and finally cured with 2.5 joules per $cm^2$ of UV energy.

The cured solder mask exhibited the following performance characteristics: a smooth, uniform, glossy, and flexible coating having 100% adhesion under a cross-hatch tape test both before and after application of solder, resistance to organic solvents of greater than 15 minutes by immersion test; excellent legend ink adhesion characteristics; excellent heat resistance as measured by a 20-second dip in solder at a temperature of 260°C. without blistering; very good surface hardness and abrasion resistance; and excellent adhesion to the printed circuit board.

Example 8

The procedure of making a solder mask was repeated using the urethane acrylate of Ex. 2 which has dicarboxylic acid terminal groups, to provide another solder mask with advantageous properties.

Example 9

The procedures of the above examples were repeated using a polyol mixture of 20 mole % of dihydroxydiphenylsulfone and 80 mole % of glycerol as the polyol in the synthesis of the urethane acrylates. The solder masks using this polyol showed improved heat resistance as compared to those using glycerol alone.

**Claims**

1. A UV curable, aqueous alkaline developable urethane acrylate composition comprising the reaction product of substantially equal molar quantities of a diisocyanate and a hydroxyalkylacrylate, with a polyol having at leaast three hydroxyl groups, and at least one mole of a dicarboxylic acid anhydride per mole of said polyol, characterized in that said diisocyanate is an aliphatic or cycloaliphatic diisocyanate.

2. A composition according to claim 1, wherein said composition comprises

(a) 40—70% weight of (i) a urethane acrylate compound which is the reaction product of claim 1, or (ii) a mixture of 20—99% by weight of said urethane acrylate compound and 1—80% by weight of a urethane diacrylate, made by reacting said diisocyanate with 2 moles of a hydroxyalkylacrylate;

(b) 20—50% by weight of one or more reactive diluent monomers;

(c) 0.5—10% by weight of a photoinitiator; and

(d) 0—8% of triphenylphosphite.

3. A composition according to claim 1 or 2, wherein said dicarboxylic acid anhydride is an unsaturated dicarboxylic acid anhydride.

4. A composition according to claim 2, wherein said reactive monomer diluent includes a mono, di- or triacrylate monomer, preferably an hydroxyalkyl acrylate or an aryloxyalkyl acrylate.

5. A UV curable, aqueous developable composition according to claim 2, wherein both said urethane acrylate is present in an amount of 30—70% by weight of said mixture, and said urethane diacrylate is present in an amount of about 30—70% by weight of said mixture.

6. A composition according to claim 1 in which said urethane acrylate has the following formula:

$$H_2C{=}CH\overset{O}{\overset{\|}{C}}OR_2{-}O{-}\overset{O}{\overset{\|}{C}}{-}NHR_1NH{-}\overset{O}{\overset{\|}{C}}{-}OR_3(OH)_y(O\overset{O}{\overset{\|}{C}}R_4COOH)_n, \text{ where}$$

$R_1$ is aliphatic or cycloaliphatic,

$R_2$ and $R_3$ are alkylene,

$R_4$ is aliphatic or cycloaliphatic, saturated or unsaturated, y is 0—4 and n is 1—5, provided that if y is 0, then n is at least 2.

7. A composition according to claim 6 in which y is 1 and n is 1, or y is 0 and n is 2.

8. A composition according to claim 1 wherein said urethane acrylate compound is characterized by terminal ethylenic unsaturation, at least one terminal carboxylic acid group, and an alkylene group intermediate said terminal groups substituted with a hydroxyl group, optionally substituted with a hydroxyl group.

9. A UV curable, aqueous alkaline developable urethane acrylate compound of the type used in claim 1 comprising the reaction product of substantially equal molar quantities of a diisocyanate compound and a hydroxyalkyl acrylate, with a polyol having at least three hydroxyl groups, and at least one mole of a dicarboxylic acid anhydride per mole of said polyol, characterized in that an aliphatic or cycloaliphatic diisocyanate compound is used.

10. A compound according to claim 9 wherein said dicarboxylic acid anhydride is an unsaturated dicarboxylic acid anhydride.

11. A compound according to claim 9 wherein said urethane acrylate compound has terminal ethylenic unsaturation, at least one terminal carboxylic group and an alkylene group intermediate said terminal groups substituted with a hydroxyl group, optionally substituted with an hydroxyl group.

12. A UV curable, aqueous alkaline developable urethane acrylate compound according to claim 9 having the formula:

$$H_2C{=}CH\overset{O}{\overset{\|}{C}}OR_2{-}O{-}\overset{O}{\overset{\|}{C}}{-}NHR_1NH{-}\overset{O}{\overset{\|}{C}}{-}OR_3(OH)_y(O\overset{O}{\overset{\|}{C}}R_4COOH)_n, \text{ where}$$

where

$R_1$ is aliphatic or cycloaliphatic,

$R_2$ and $R_3$ are alkylene,

$R_4$ is aliphatic or cycloaliphatic, saturated or unsaturated, or aromatic,

y is 0—4, and

n is 1—5; provided that if y is 0, then n is at least 2.

13. A UV curable, aqueous alkaline developable urethane acrylate compound according to claim 9 having the formula:

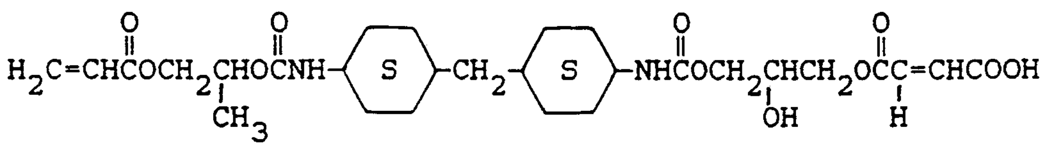

**Patentansprüche**

1. UV-härtbare, wässerig-alkalisch entwickelbare Urethanacrylatzusammensetzung, bestehend aus dem Reaktionsprodukt von im wesentlichen äquimolaren Mengen eines Diisocyanats und eines Hydroxyalkylacrylats mit einem Polyol mit wenigstens drei Hydroxylgruppen und wenigstens einem Mol eines Dicarbonsäureanhydrids pro Mol des Polyols, dadurch gekennzeichnet, daß das Diisocyanat eine aliphatisches oder cycloaliphatisches Diisocyanat ist.

2. Zusammensetzung nach Anspruch 1, dadurch gekennzeichnet, daß sie aus

(a) 40—70 Gew.-% (i) einer Urethanacrylatverbindung, welche das Reaktionsprodukt von Anspruch 1 ist, oder (ii) einem Gemisch von 20—99 Gew.-% der Urethanacrylatverbindung und 1—80 Gew.-% eines Urethandiacrylats, hergestellt durch Umsetzung des Diisocyanats mit 2 Molen eines Hydroxyalkylacrylats;

(b) 20—50 Gew.-% eines oder mehrerer reaktiver Verdünnungsmonomeren;

(c) 0,5—10 Gew.-% eines Photoinitiators; und

(d) 0—8% Triphenylphosphit, besteht.

3. Zusammensetzung nach Anspruch 1 oder 2, dadurch gekennzeichnet, daß das Dicarbonsäureanhydrid ein ungesättigtes Dicarbonsäureanhydrid ist.

4. Zusammensetzung nach Anspruch 2, dadurch gekennzeichnet, daß das reaktive monomere Verdünnungsmittel aus einem Mono-, Di- oder Triacrylatmonomer, vorzugsweise einem Hydroxyalkylacrylat oder einem Aryloxyalkylacrylat, besteht.

5. UV-härtbare, wässerig-alkalisch entwickelbare Zusammensetzung nach Anspruch 2, dadurch gekennzeichnet, daß sowohl das Urethanacrylat in einer Menge von 30—70 Gew.-% des Gemisches als auch das Urethandiacrylat in einer Menge von etwa 30—70 Gew.-% des Gemisches zugegen ist.

6. Zusammensetzung nach Anspruch 1, dadurch gekennzeichnet, daß das Urethanacrylat folgende Formel besitzt:

$$H_2C{=}CH\overset{O}{\overset{\|}{C}}OR_2{-}O\overset{O}{\overset{\|}{C}}{-}NHR_1NH{-}\overset{O}{\overset{\|}{C}}{-}OR_3(OH)_y(O\overset{O}{\overset{\|}{C}}R_4COOH)_n$$

worin

$R_1$ aliphatisch oder cycloaliphatisch ist,

$R_2$ und $R_2$ Alkylen sind

$R_4$ aliphatisch oder cycloaliphatisch, gesättigt oder ungesättigt ist, Y is 0—4 und n ist 1—5, mit der Maßgabe, daß, wenn Y is 0, dann ist n wenigstens 2.

7. Zusammensetzung nach Anspruch 6, dadurch gekennzeichnet, daß y 1 und n 1 oder y 0 und n 2 ist.

8. Zusammensetzung nach Anspruch 1, in welcher die genannte Urethanacrylatverbindung durch eine endständige ethylenische Unsättigung, wenigstens eine endständige Carbonsäuregruppe und eine Alkylengruppe zwischen den genannten endständigen Gruppen, substituiert mit einer Hydroxylgruppe, gegebenenfalls substituiert mit einer Hydroxylgruppe, gekennzeichnet ist.

9. UV-härtbare, wässerig-alkalisch entwickelbare Urethanacrylatverbindung von der in Anspruch 1 verwendeten Art, bestehend aus dem Reaktionsprodukt von im wesentlichen äquimolaren Mengen einer Diisocyanatverbindung und eines Hydroxyalkylacrylats mit einem Polyol mit wenigstens drei Hydroxylgruppen und wenigstens einem Mol eines Dicarbonsäureanhydrids pro Mol des Polyols, dadurch gekennzeichnet, daß eine aliphatische oder cycloaliphatische Diisocyanatverbindung verwendet wird.

10. Verbindung nach Anspruch 9, dadurch gekennzeichnet, daß das Dicarbonsäureanhydrid ein ungesättigtes Dicarbonsäureanhydrid ist.

11. Verbindung nach Anspruch 9, dadurch gekennzeichnet, daß die Urethanacrylatverbindung eine endständige ethylenische Unsättigung, wenigstens eine endständige Carboxylgruppe und eine Alkylengruppe zwischen den genannten endständigen Gruppen, substituiert mit einer Hydroxylgruppe, gegebenenfalls substituiert mit einer Hydroxylgruppe, aufweist.

12. UV-härtbare, wässerig-alkalisch entwickelbare Urethanacrylatverbindung nach Anspruch 9 mit der Formel:

$$H_2C{=}CH\overset{O}{\overset{\|}{C}}OR_2{-}O\overset{O}{\overset{\|}{C}}{-}NHR_1NH{-}\overset{O}{\overset{\|}{C}}{-}OR_3(OH)_y(O\overset{O}{\overset{\|}{C}}R_4COOH)_n$$

worin

$R_1$ aliphatisch oder cycloaliphatisch ist,

$R_2$ und $R_2$ Alkylen sind

$R_4$ aliphatisch oder cycloaliphatisch, gesättigt oder ungesättigt oder aromatisch ist,

Y 0—4 ist

und n 1—5 ist, mit der Maßgabe, daß, wenn Y 0 ist, dann ist n wenigstens 2.

13. UV-härtbare, wässerig-alkalisch entwickelbare Urethanacrylatverbindung nach Anspruch 9 mit der Formel:

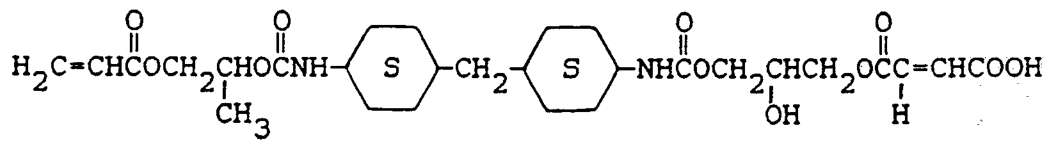

## Revendications

1. Composition d'acrylate d'uréthane développable en solution aqueuse alcaline et durcissable aux rayons UV, comprenant le produit de la réaction de quantités molaires pratiquement égales d'un diisocyanate et d'un hydroxyalkylacrylate, avec un polyol ayant au moins trois groupes hydroxyle, et au moins une mole d'un anhydride d'acide dicarboxylique par mole dudit polyol, caractérisée en ce que ledit diisocyanate est un diisocyanate aliphatique ou cycloaliphatique.

2. Une composition selon la revendication 1, dans laquelle ladite composition comprend:

(a) 40 à 70% en poids de (i) un composé à base d'acrylate d'uréthane obtenu par réaction de quantités molaires pratiquement égales d'un diisocyanate aliphatique ou cycloaliphatique et d'un acrylate d'hydroxyalkyle avec un polyol présentant au moins trois groupes hydroxyle, au moins une mole d'un anhydride d'acide dicarboxylique par mole dudit polyol; ou (ii) un mélange de 20 à 99% en poids dudit acrylate d'uréthane et de 1 à 80% en poids d'un diacrylate d'uréthane, obtenu par réaction dudit diisocyanate avec 2 moles d'un hydroalkylacrylate;

(b) 20 à 50% en poids d'un ou plusieurs diluants monomères réactifs;

(c) 0,5 à 10% en poids d'un photo-initiateur; et

(d) 0 à 8% en poids de triphénylphospite.

3. Une composition selon la revendication 1 ou 2, dans laquelle ledit anhydride d'acide dicarboxylique est un anhydride d'acide dicarboxylique insaturé.

4. Une composition selon la revendication 2, dans laquelle ledit diluant monomère réactif comprend un monomère de mono, di- ou triacrylate, de préférence un hydroxyalkylacrylate ou un aryloxyalkylacrylate.

5. Une composition développable en solution aqueuse alcaline et durcissable aux rayons ultraviolets, selon la revendication 2, dans laquelle l'acrylate d'uréthane est présent en une proportion de 30 à 70% en poids dudit mélange, et le diacrylate d'uréthane est présent en une proportion d'environ 30 à 70% en poids dudit mélange.

6. Une composition selon la revendication 1, dans laquelle l'acrylate d'uréthane présente la formule suivante:

$$H_2C{=}CH\overset{O}{\overset{\|}{C}}OR_2-O\overset{O}{\overset{\|}{C}}-NHR_1NH-\overset{O}{\overset{\|}{C}}-OR_3(OH)_y(O\overset{O}{\overset{\|}{C}}R_4COOH)_n$$

dans laquelle

$R_1$ est un radical aliphatique ou cycloaliphatique,

$R_2$ et $R_3$ sont des radicaux alkylène,

$R_4$ est un radical aliphatique ou cycloaliphatique, saturé ou insaturé, y est compris entre 0 et 4 et n est compris entre 1 et 5, étant entendu que si y est égal à 0, alors n est égal à au moins 2.

7. Une composition selon la revendication 6, dans laquelle y est égal à 1 et n est égal à 1, ou bien y est égal à 0 et n est égal à 2.

8. Une composition selon la revendication 1, dans laquelle l'acrylate d'uréthane est caractérisé par une insaturation éthylénique terminale, au moins un groupe acide carboxylique terminal, et un groupe alkylène intermédiaire, ces groupes terminaux étant substitués par un groupe hydroxyle, éventuellement substitué par un groupe hydroxyle.

9. Un composé d'acrylate d'uréthane développable en solution aqueuse alcaline et durcissable aux rayons ultraviolets, du type utilisé dans la revendication 1, comprenant le produit de réaction de quantités molaires pratiquement égales d'un diisocyanate et d'un hydroxyalkylacrylate, avec un polyol présentant au moins trois groupes hydroxyle, et au moins une mole d'un anhydride d'acide dicarboxylique par mole dudit polyol, caractérisé en ce qu'on utilise un diisocyanate aliphatique ou cycloaliphatique.

10. Un composé selon la revendication 9, dans lequel l'anhydride d'acide dicarboxylique est un anhydride d'acide dicarboxylique insaturé.

11. Un composé selon la revendication 9, dans lequel l'acrylate d'uréthane présente une insaturation

éthylénique terminale, au moins un groupe carboxylique terminal et un groupe alkylène intermédiaire, ces groupes terminaux étant substitués par un groupe hydroxyle, éventuellement substitué par un groupe hydroxyle.

12. Un composé d'acrylate d'uréthane développable en solution aqueuse alcaline et durcissable aux rayons ultraviolets selon la revendication 9, présentant la formule:

$$H_2C{=}CH\overset{O}{\overset{\|}{C}}OR_2{-}O\overset{O}{\overset{\|}{C}}{-}NHR_1NH{-}\overset{O}{\overset{\|}{C}}{-}OR_3(OH)_y(O\overset{O}{\overset{\|}{C}}R_4COOH)_n$$

dans laquelle

$R_1$ est un radical aliphatique ou cycloaliphatique,

$R_2$ et $R_3$ sont des radicaux alkylène,

$R_4$ est un radical aliphatique ou cycloaliphatique, saturé ou insaturé, ou un radical aromatique,

y est compris entre 0 et 4,

et n est compris entre 1 et 5; étant entendu que si y est égal à 0, alors n est égal à au moins 2.

13. Un composé d'acrylate d'uréthane durcissable aux rayons ultraviolets et développable en solution aqueuse alcaline selon la revendication 9, présentant la formule: